# EUROPÄISCHE PATENTSCHRIFT

(11) **EP 2 545 202 B1**
(45) Veröffentlichungstag und Bekanntmachung des Hinweises auf die Patenterteilung: **03.09.2014**
(21) Anmeldenummer: 11704223.4
(22) Anmeldetag: 17.02.2011
(51) Int. Cl.: C23C 28/00, C23C 28/04, C23C 30/00, C23C 14/06, F16J 9/26

(54) **KOLBENRING, UND VERFAHREN ZUR BESCHICHTUNG EINES KOLBENRINGS**
PISTON RING, AND METHOD FOR COATING A PISTON RING
SEGMENT DE PISTON, ET PROCÉDÉ DE REVÊTEMENT D'UN SEGMENT DE PISTON

(30) Priorität: 09.03.2010 DE 102010002686
(43) Veröffentlichungstag der Anmeldung: 16.01.2013
(73) Patentinhaber: Federal-Mogul Burscheid GmbH, 51399 Burscheid (DE)
(72) Erfinder: KENNEDY, Marcus, 40479 Düsseldorf (DE); ZINNABOLD, Michael, 51399 Burscheid (DE)
(74) Vertreter: HOFFMANN EITLE
(86) Internationale Anmeldenummer: PCT/EP2011/052345
(87) Internationale Veröffentlichungsnummer: WO 2011/110413

(56) Entgegenhaltungen:
- WO-A1-98/58100
- WO-A1-2006/125683
- WO-A2-2009/121719
- JP-A- 2003 247 060
- PAL S K ET AL: "Effects of N-doping on the microstructure, mechanical and tribological behavior of Cr-DLC films", SURFACE AND COATINGS TECHNOLOGY, ELSEVIER, AMSTERDAM, NL, Bd. 201, Nr. 18, 25. Juni 2007 (2007-06-25), Seiten 7917-7923, XP025317810, ISSN: 0257-8972, DOI: DOI:10.1016/J.SURFCOAT.2007.03.036 [gefunden am 2007-05-25]

## Beschreibung

### Gebiet der Erfindung

Die Erfindung betrifft einen Kolbenring mit einer Beschichtung, sowie ein Verfahren zur Beschichtung eines Kolbenrings.

In zahlreichen technischen Anwendungsfällen stehen Gleitelemente in gleitendem Kontakt mit Laufpartnern. Als typischer Anwendungsfall kann die Kombination eines Kolbenringes mit einer Zylinderlaufbuchse gesehen werden. Solange die Zylinder oder Zylinderlaufbuchsen beispielsweise aus Aluminium-Silizium Legierungen ausgeführt sind, was insbesondere bei Otto-Motoren der Fall ist, haben sich DLC (diamond like carbon)-Beschichtungssysteme im Hinblick auf Verschleiß und Reibleistung bewährt. Die bekannten DLC-Schichtsysteme sind jedoch im Hinblick auf die Lebensdauer sowie auf ihre Anwendbarkeit bei Diesel- oder hoch aufgeladenen Otto-Motoren mit üblicherweise eisenbasierten Zylinderlaufbuchsen verbesserungswürdig. Wegen der deutlich höheren Zylinderdrücke und insbesondere in Kombination mit Direkteinspritzung tritt ein erhöhter Anteil an Mischreibung auf. Als maßgeblicher Grund für die mangelhafte Eignung der DLC-Beschichtungssysteme für derartige Situationen wird die üblicherweise geringe Schichtdicke, von weniger als 5 µm, gesehen.

### Stand der Technik

Aus der DE 10 2005 063 123 B3 geht eine DLC-Beschichtung mit einer Einlaufschicht hervor. Im Hinblick auf höhere Schichtdicken sind ferner PVD-Beschichtungen, insbesondere auf der Basis von CrN bekannt, die Schichtdicken im Bereich von 10-30 µm aufweisen. Hierdurch ergibt sich zwar eine verbesserte Lebensdauer, jedoch verschlechtern sich die Reibleistung und der Verschleißwiderstand, insbesondere bei Mangelschmierung, sowie die Brandspursicherheit. Dem gegenüber bieten DLC-Schichtsysteme aufgrund ihrer amorphen Struktur den Vorteil, dass sie eine weitgehende chemische Inaktivität mit metallischen Oberflächen und damit eine äußerst geringe adhäsive Neigung gegenüber dem Laufpartner aufweisen.

Dies gilt beispielsweise für die Beschichtung gemäß der DE 10 2008 016 864 B3, die innen eine metallhaltige amorphe Kohlenstoffschicht und außen eine metallfreie amorphe Kohlenstoffschicht aufweist.

### Darstellung der Erfindung

Der Erfindung liegt die Aufgabe zugrunde, einen Kolbenring zu schaffen, der insbesondere beim Einsatz in Diesel- oder hoch aufgeladenen Otto-Motoren mit beispielsweise eisenbasierten Laufpartnern die Anforderungen im Hinblick auf die Lebensdauer und die Reibleistung erfüllt. Ferner soll ein Verfahren zur Beschichtung eines Kolbenrings angegeben werden.

Die Lösung dieser Aufgabe erfolgt durch den in Anspruch 1 beschriebenen Kolbenring.

Die daran vorgesehene Beschichtung zeichnet sich durch mehrere alternierende Lagen von CrN- und a-C:H:Me-Schichten aus. Bei ersten Versuchen hat sich herausgestellt, dass durch einen derartigen Schichtaufbau sowohl die Lebensdauer als auch der relative Reibwert verbessert werden kann.

Der guten Ordnung halber sei erwähnt, dass Me für Metall steht und hierfür beispielsweise Wolfram, Chrom, Titan oder Silizium verwenden werden können. Sowohl die a-C:H:Me als auch die nachfolgend erwähnte a-C:H-Schicht sind DLC-Schichten und sorgen für einen vergleichsweisen geringen Verschleiß und gute Reibungseigenschaften. Insbesondere wird davon ausgegangen, dass, verursacht durch unterschiedliche radiale Anpressdrücke und dadurch erzeugte unterschiedliche Verschleißraten, beispielsweise über den Umfang eines Kolbenrings, dennoch auf der Ringoberfläche immer zumindest teilweise DLC vorhanden ist, so dass die guten Reibeigenschaften, insbesondere auch unter Mangelschmierbedingungen, erhalten bleiben. Dies wird in vorteilhafter Weise kombiniert mit Vorteilen, welche die CrN-Schicht im Hinblick auf den Verschleiß bietet. Der gegenüber DLC üblicherweise höhere Verschleißwiderstand der CrN-Schicht kann in vorteilhafter Weise von Anfang an, bzw. wenn die äußerste DLC-Schicht verschlissen ist, wirksam werden. Die beschriebene, mehrlagige Beschichtung bietet darüber hinaus den Vorteil, dass deutlich höhere Gesamtschichtdicken als bei herkömmlichen DLC-Schichtsystemen realisiert werden können. Dies beruht im Wesentlichen darauf, dass die bei DLC gegenüber CrN höheren Eigenspannungen durch die CrN-Lagen innerhalb der Beschichtung insgesamt ausgeglichen werden können.

Die Beschichtung kann insbesondere zumindest bereichsweise auf zumindest einer Lauffläche vorgesehen sein. Ferner kann sich die Beschichtung in den Übergang zu Flächen und auf Flächen erstrecken, die an die Laufflächen benachbart sind. Dies betrifft beispielsweise die Laufflanken eines Kolbenringes. Es sei ferner erwähnt, dass von der Anmelderin am gleichen Tag eine Anmeldung mit dem Titel "Schraubendruckfeder für einen Ölabstreifring eines Kolbens in einem Verbrennungsmotor und Verfahren zur Beschichtung einer Schraubendruckfeder" eingereicht wurde, in der eine ähnliche Beschichtung wie hierin beschrieben für eine Schraubendruckfeder angegeben ist. Sämtliche Merkmale der dort angegebenen Beschichtung sind auch auf die hierin beschriebene Beschichtung anwendbar. Ferner ist die in der genannten Anmeldung beschriebene Schraubendruckfeder in einer der dort beschriebenen Ausführungsformen in vorteilhafter Weise mit dem hierin beschriebenen Kolbenring kombinierbar und in dieser Kombination als Gegenstand der vorliegenden Anmeldung anzusehen. Ferner wurde von der Anmelderin am gleichen Tag eine Anmeldung mit dem Titel "Verfahren zur Beschichtung zumindest der Innenfläche eines Kolbenrings sowie Kolbenring" eingereicht. Sämtliche darin beschriebenen Maßnahmen, die sich insbesondere auf die Beschichtung der Innenfläche eines Kolbenrings beziehen, können auf den hierin beschriebenen Kolbenring angewendet werden, und das in der genannten Anmeldung beschriebene Verfahren kann insbesondere auch auf die Beschichtung anderer Flächen als der Innenfläche angewendet werden.

Bevorzugte Weiterbildungen sind in den weiteren Ansprüchen beschrieben.

Für die Haftung der CrN-Schicht auf dem Substrat, also dem Kolbenring, vorzugsweise aus Gusseisen oder Stahl, hat es sich als vorteilhaft erwiesen, eine Haftschicht aus Chrom auszubilden. Diese kann insbesondere aufgedampft sein und weist bevorzugt eine Schichtdicke von weniger als 1,0 µm auf. Als minimale Schichtdicke der Haftschicht wird derzeit 0,01 µm bevorzugt.

Insbesondere mit der vorangehend beschriebenen Haftschicht wird derzeit bevorzugt, eine CrN-Schicht als innerste Schicht des oben beschriebenen mehrlagigen Aufbaus zu wählen.

Für die äußerste Schicht des erfindungsgemäßen Kolbenrings, der sich zunächst in Gleitberührung mit dem Laufpartner befindet, wird eine metallfreie DLC-Schicht, mit anderen Worten eine Schicht des Typs a-C:H bevorzugt. Eine derartige Schicht gewährleistet ein bestmögliches Einlaufverhalten. Als Dicke dieser Schicht haben sich 0,1 bis 5,0 µm als vorteilhaft erwiesen. Die Mindestschichtdicke von 0,1 µm ist für ein gutes Einlaufverhalten vorteilhaft. Die maximale Schichtdicke ergibt sich aufgrund der Mindesthaftfestigkeit, die bei dickeren Schichten geringer wird. Für die beschriebene äußerste oder Top-Schicht ist das Auftragen sowohl auf eine CrN - als auch eine a-C:H:Me-Schicht denkbar.

Für die Einzellagen der CrN- und a-C:H:Me-Schicht werden 50 nm bis 400 nm bevorzugt. Eine Dicke von mehr als 50 nm bietet den Vorteil, dass bei der Anwendung in der Serie die Prüffähigkeit des Schichtaufbaus gewährleistet wird.

Die Gesamtdicke der Beschichtung beträgt in vorteilhafter Weise, um mit einer guten Lebensdauer ein gutes Reibverhalten zu gewährleisten, 2 bis 40 µm. In diesem Zusammenhang kann die Anzahl der Einzellagen beispielsweise zwischen 10 und 400 liegen.

Für die Härte der CrN-Schicht haben sich Werte von 800-1900 HV 0,002 bewährt. Diese Ausbildung kann mit einer Härte der metallfreien der DLC-Schicht von 1700-2900 HV 0,002 und/oder einer Härte der metallhaltigen DLC-Schicht von 800-1600 HV 0,002 kombiniert werden.

Es wird ferner erwartet, dass sich besonders gute Eigenschaften der DLC-Schicht, insbesondere der metallhaltigen und/oder metallfreien DLC-Schicht einstellen, wenn diese Wasserstoff enthält.

Die metallhaltige DLC-Schicht kann ferner in vorteilhafter Weise nanokristalline Metallkarbidausscheidungen, wie z. B. WC, CrC, SiC, GeC oder TiC enthalten.

Die Lösung der oben genannten Aufgabe erfolgt ferner durch das im Anspruch 9 beschriebene Verfahren.

In vorteilhafter Weise kann die beschriebene Beschichtung im Rahmen des erfindungsgemäßen Verfahrens durch eine Kombination aus Sputtern und PA-CVD-Verfahren hergestellt werden.

Es wird ferner eine Kombination zumindest eines vorangehend beschriebenen Kolbenrings mit einem Laufpartner, insbesondere einem Zylinder oder einer Zylinderlaufbuchse eines Verbrennungsmotors, insbesondere eines Diesel- oder hoch aufgeladenen Otto-Motors, wobei der Laufpartner eisenbasiert ist, offenbart.

### Kurze Beschreibung der Zeichnungen

Nachfolgend wird ein bevorzugtes Ausführungsbeispiel der Erfindung unter Bezugnahme auf die Zeichnungen näher erläutert. Es zeigen:
- Figur 1: einen erfindungsgemäßen Schichtaufbau; und
- Figur 2: den relativen Verschleiß eines Kolbenrings mit verschiedenen Beschichtungen.

### Ausführliche Beschreibung eines bevorzugten Ausführungsbeispiels der Erfindung

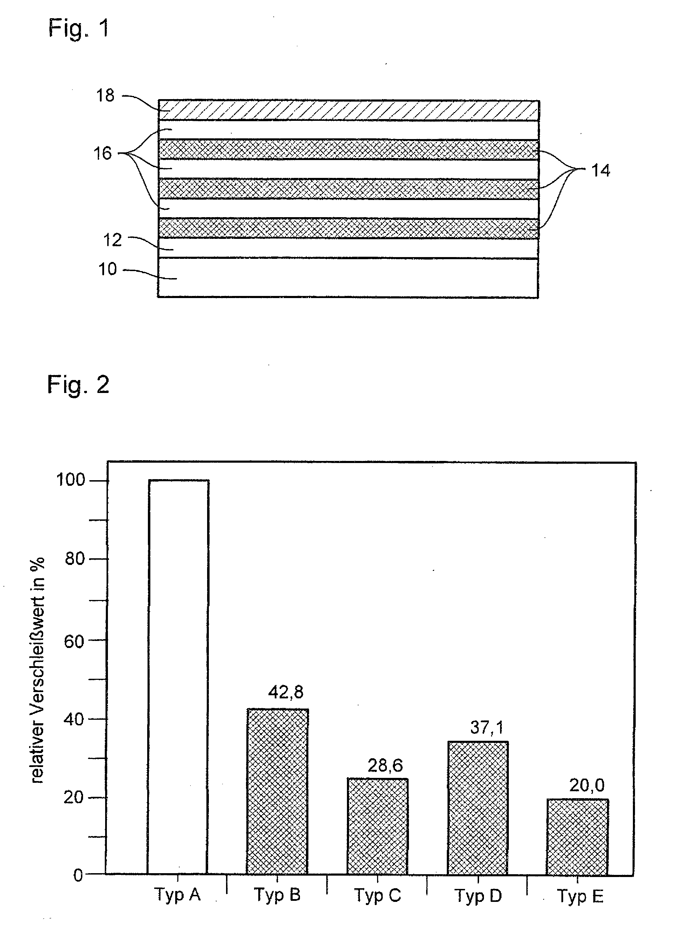

Wie aus fig. 1 hervorgeht, ist auf dem Grundwerkstoff 10 des Kolbenrings zunächst eine Chrom-Haftschicht 12 aufgebracht. Darauf sind von innen nach außen alternierend mehrere CrN-Schichten 14 und a-C:H:Me-Schichten 16 aufgebracht. Die äußerste Schicht wird durch eine a-C:H-Schicht gebildet. Bei dem gezeigten Beispiel ist diese auf einer DLC-Schicht aufgebracht, sie kann jedoch ebenso auf einer CrN-Schicht aufgetragen werden.

Mit einem derartigen Aufbau wurden Versuche mit Vergleichsbeispielen durchgeführt. Die Tabelle zeigt die verwendeten Schichtsysteme.

| Variante | | Schichtaufbau | | | |
|---|---|---|---|---|---|
| | | Substrat | ← | → | Lauffläche |
| | | Haftschicht | Unterbau | Zwischenschicht | Topschicht |
| A | Unbeschichtet | - | - | - | - |
| B | DLC double layer 01 | Cr | - | | a-C:H-01 |
| C | DLC double layer 02 | Cr | - | Me(CN)x | a-C:H-02 |
| D | DLC double layer 3 | Cr | CrN | Cr | a-C:H |
| E | Multilayer DLC | Cr | CrN / a-C:H:W alternierend | | a-C:H |

Diese Schichtsysteme wurden auf einen Kolbenring aufgebracht, und es wurde das tribologische Verhalten in Kombination mit einer gehonten Grauguss-Zylinderlaufbuchse in geschmiertem Zustand untersucht. Das Schichtsystem, das den größten Verschleiß aufweist, wird mit 100 % definiert. Aus Fig. 2 wird zum einen deutlich, dass durch eine DLC-Beschichtung, verglichen mit einer unbeschichteten Oberfläche, der Verschleiß um über 50 % reduziert wird. Das erfindungsgemäße Schichtsystem (Typ E) weist den geringsten relativen Verschleiß auf. Dies wird nach ersten Erkenntnissen durch den stabileren Aufbau des Mehrschichtsystems und das dadurch optimierte Reib- und Verschleißverhalten erreicht.

## Patentansprüche

1. Kolbenring, bevorzugt aus Gusseisen oder Stahl, mit einer Beschichtung, die alternierend mehrere Lagen von CrN-(14) und a-C:H:Me-Schichten (16) aufweist.

2. Kolbenring nach Anspruch 1, **dadurch gekennzeichnet, dass** auf ein Substrat (10) des Kolbenrings eine Haftschicht aus Chrom (12) aufgebracht ist, die vorzugsweise 0,01 bis 1,0 µm dick ist.

3. Kolbenring nach Anspruch 1 oder 2, **dadurch gekennzeichnet, dass** die innerste der alternierenden Lagen eine CrN-Schicht (14) ist.

4. Kolbenring nach einem der vorangehenden Ansprüche, **dadurch gekennzeichnet, dass** die äusserste Schicht der Beschichtung eine a-C:H-Schicht (18) bevorzugt mit einer Dicke von 0,1 bis 5,0 µm ist.

5. Kolbenring nach einem der vorangehenden Ansprüche, **dadurch gekennzeichnet, dass** die CrN- und/oder a-C:H:Me-Lagen eine Dicke von jeweils 50 nm bis 400 nm aufweisen.

6. Kolbenring nach einem der vorangehenden Ansprüche, **dadurch gekennzeichnet, dass** die Beschichtung insgesamt eine Dicke von 2 bis 40 µm aufweist.

7. Kolbenring nach einem der vorangehenden Ansprüche, **dadurch gekennzeichnet, dass** die Härte der CrN-Schicht bei 800-1900 HV 0,002 und/oder die Härte der metallfreien DLC-Schicht bei 1700-2900 HV 0,002 und/oder die Härte der metallhaltigen DLC-Schicht bei 800-1600 HV 0,002 liegt.

8. Kolbenring nach einem der vorangehenden Ansprüche, **dadurch gekennzeichnet, dass** zumindest eine DLC-Schicht metallisch aufgedampft und/oder die metallhaltige und/oder die metallfreie DLC-Schicht mittels PA-CVD-Verfahren hergestellt ist.

9. Verfahren zur Beschichtung eines Kolbenrings, bevorzugt aus Gusseisen oder Stahl, bei dem mehrere Lagen von CrN-und a-C:H:Me-Schichten alternierend aufgebracht werden.

10. Verfahren nach Anspruch 9, **dadurch gekennzeichnet, dass** die Beschichtung durch eine Kombination aus Sputtern und PA-CVD erzeugt wird.

## Claims

1. Piston ring, preferably made from cast iron or steel, with a coating which has alternately several laminae of CrN layers (14) and a-C:H:Me layers (16).

2. Piston ring according to claim 1, **characterised in that** an adhesive layer made from chromium (12), which is preferably 0.01 to 1.0 µm thick, is applied to a substrate (10) of the piston ring.

3. Piston ring according to claim 1 or 2, **characterised in that** the innermost of the alternating laminae is a CrN layer (14).

4. Piston ring according to one of the preceding claims, **characterised in that** the outermost layer of the coating is an a-C:H layer (18) preferably with a thickness of 0.1 to 5.0 µm.

5. Piston ring according to one of the preceding claims, **characterised in that** the CrN laminae and/or a-C:H:Me laminae have a thickness of in each case 50 nm to 400 nm.

6. Piston ring according to one of the preceding claims, **characterised in that** the coating has altogether a thickness of 2 to 40 µm.

7. Piston ring according to one of the preceding claims, **characterised in that** the hardness of the CrN layer is 800-1,900 HV 0.002 and/or the hardness of the metal-free DLC layer is 1,700-2,900 HV 0.002 and/or the hardness of the metal-containing DLC layer is 800-1,600 HV 0.002.

8. Piston ring according to one of the preceding claims, **characterised in that** at least one DLC layer is metallically vapour-deposited and/or the metal-containing and/or the metal-free DLC layer is produced by means of PA-CVD methods.

9. Method for coating a piston ring, preferably made from cast iron or steel, in which several laminae of CrN layers and a-C:H:Me layers are applied alternately.

10. Method according to claim 9, **characterised in that** the coating is generated by a combination of sputtering and PA-CVD.

## Revendications

1. Segment de piston, de préférence en fonte ou en acier, comprenant un revêtement qui présente en alternance plusieurs empilements de couches de CrN (14) et de a-C :H :Me (16).

2. Segment de piston selon la revendication 1, **caractérisé en ce qu'**une couche d'adhérence en chrome (12) qui a de préférence une épaisseur de 0,01 à 1,0 µm est déposée sur un substrat (10) du segment de piston.

3. Segment de piston selon la revendication 1 ou 2, **caractérisé en ce que** le plus interne des empilements de couches alternés est une couche de CrN (14).

4. Segment de piston selon une des revendications précédentes, **caractérisé en ce que** la couche la plus externe du revêtement est une couche de a-C :H (18) ayant de préférence une épaisseur de 0,1 à 5,0 µm.

5. Segment de piston selon une des revendications précédentes, **caractérisé en ce que** les empilements de couches de CrN et/ou a-C :H :Me présentent une épaisseur de 50 nm à 400 nm, respectivement.

6. Segment de piston selon une des revendications précédentes, **caractérisé en ce que** le revêtement présente au total une épaisseur de 2 à 40 µm.

7. Segment de piston selon une des revendications précédentes, **caractérisé en ce que** la dureté de la couche de CrN à 800-1900 HV est de 0,002 et/ou la dureté de la couche DLC dépourvue de métal à 1700-2900 HV est de 0,002 et/ou la dureté de la couche DLC contenant du métal à 800-1600 HV est de 0,002.

8. Segment de piston selon une des revendications précédentes, **caractérisé en ce qu'**au moins une couche DLC est vaporisée par voie métallique et/ou la couche DLC contenant du métal et/ou dépourvue de métal est fabriquée au moyen de procédés PA-CVD.

9. Procédé de revêtement d'un segment de piston, de préférence en fonte ou en acier, dans lequel plusieurs empilements de couches de CrN et de a-C :H :Me sont déposées en alternance.

10. Procédé selon la revendication 9, **caractérisé en ce que** le revêtement est produit par une combinaison de pulvérisation et de PA-CVD.
